Europäisches Patentamt

European Patent Office

Office européen des brevets

(11) Publication number: **0 288 776**
**A2**

## (12) EUROPEAN PATENT APPLICATION

(21) Application number: **88105266.6**

(22) Date of filing: **31.03.88**

(51) Int. Cl.4: **H01L 21/60 , H01L 23/48**

(30) Priority: **28.04.87 US 43290**

(43) Date of publication of application:
**02.11.88 Bulletin 88/44**

(84) Designated Contracting States:
**DE FR GB**

(71) Applicant: **TEXAS INSTRUMENTS
INCORPORATED
13500 North Central Expressway
Dallas Texas 75265(US)**

(72) Inventor: **Brook, Richard M.
300 Hwy. 1417N. Apt. 2A
Sherman Texas 75090(US)**
Inventor: **Ramsey, Thomas H.
602 Carroll Drive
Garland Texas 75041(US)**

(74) Representative: **Leiser, Gottfried, Dipl.-Ing. et
al
Patentanwälte Prinz, Leiser, Bunke & Partner
Manzingerweg 7
D-8000 München 60(DE)**

(54) Gold alloy wire connection to copper doped aluminum semiconductor circuit interconnection bonding pad.

(57) The disclosure relates to an electrical connection between a bonding pad on a semiconductor chip and a wire wherein the bonding pad is formed of copper doped aluminum and the wire is formed of copper doped gold. The wire has from about 100 to about 10,000 parts per million copper and the pad has from about 5000 to about 50,000 parts per million copper.

EP 0 288 776 A2

# GOLD ALLOY WIRE CONNECTION TO COPPER DOPED ALUMINUM SEMICONDUCTOR CIRCUIT INTER-CONNECTION BONDING PAD

## BACKGROUND OF THE INVENTION

### FIELD OF THE INVENTION

This invention relates to an electrical connection between copper doped wire and copper doped aluminum bonding pads forming a part of a semiconductor circuit.

### BRIEF DESCRIPTION OF THE PRIOR ART

It is often desirable to utilize doped metallization in semiconductor devices. Doped aluminum matallization including the bonding pads are required to obtain certain desired metallurgical characteristics on semiconductor devices. When alloyed with copper, significantly increased hardness and toughnees of the aluminum metallization is achieved. These characteristics are fundamental to an integrated circuits's ability to withstand the thermal stress, induced in the active circuitry of the device by the expansion and contraction of plastic encapsulant. The ability of a plastic encapsulated semiconductor device to withstand stress induced during temperature cycling between -66 degrees C. and 150 degrees C. is a requirement outlined in mil-standards and by most major commercial users. As the bonding pad becomes harder, the standard gold wire becomes less apt to properly bond thereto as compared to the undoped bonding pad wherein the gold is relatively soft compared with the doped bonding pad. It is known that wires generally should be harder than the bonding pad material. The wire of choice presently used in semiconductor applications is a berrylium doped gold wire. Gold wire for use in semiconductor applications is discussed in an article entitled Metallurgical Behavior Of Gold Wire In Thermal Compression Bonding, T.H. Ramsey, Solid State Technology, October 1973, pages 43 to 47, which is incorporated herein by reference.

However, a problem exists with the current technology of thermosonic ball bonding of standard beryllium doped gold wire to copper doped aluminum metallization in the form of bonding pads due to the increased hardness and toughness in that standard gold wire of the type described hereinabove is of insufficient hardness to cause the level of plastic flow of the integrated circuit metallization as was achieved with standard aluminum integrated circuit metallization. It is therefore necessary to provide wire for bonding to copper doped aluminum pads which is of sufficient hardness to overcome the problems noted hereinabove and provide a reliable bond to the pad.

## SUMMARY OF THE INVENTION

In accordance with the present invention, the above noted problems of the prior art are materially minimized and there is provided an electrical connection to copper doped aluminum metallization in the form of bonding pads in semiconductor devices by forming gold wire which has been doped with from about 100 to about 10,000 parts per million copper and making electrical connection therewith. With such wire, the hardness is significantly increased without introducing a new metal into the system. Since copper metallization is compatible with gold, bonding results are improved for bonding of gold to copper doped aluminum.

In accordance with the present invention, gold and copper, in the desired ratio, are placed in a crucible and heating to the point where the entire mass is a liquid. The mass is than agitated, such as by ultrasonic agitation, while in the crucible to provide a uniform mixture of the gold and copper. The copper doped gold is then cooled to form a solid ingot of gold with the copper homogeneously dispersed therethrough in the predesired amount. The ingot is then drawn out in standard manner to the desired diameter to form a wire of gold doped with copper. This wire is then ball bonded to copper doped aluminum pads of semiconductor devices to provide the desired bonds as discussed hereinabove. The gold wire has from about 100 to about 10,000 parts per million copper therein.

## DESCRIPTION OF THE PREFERRED EMBODIMENT

A gold wire for use in accordance with the present invention was produced by depositing a 1000.0 gram ingot of 99.95% pure gold in a crucible of any type that does not contaminate the gold along with 5 grams of pure copper 99.99% pure copper. The crucible was placed in a nitrogen atmosphere and heated until the gold and copper had melted. While retaining the melted gold and copper at this temperature, the mixture was ultrasonically agitated for thirty minutes to thoroughly mix the gold and copper and provide a homogeneous mixture thereof. The mixture was allowed to cool to room temperature, whereupon the crucible was removed from the nitrogen atmosphere. The ingot that had been formed in the crucible was then worked in standard manner to form a spool of 1 mil diameter wire. This was accomplished by forcing the ingot through progressively smaller apertures whereby the ingot was drawn out into continually smaller diameter wires until the desired diameter was reached. A semiconductor chip having from about 0.5 to about 5% copper and preferably 2.0% copper doped aluminum bonding pads thereon was then provided and a piece of the copper doped wire was ball bonded thereto in standard manner as discussed in the above noted publication. The bond was then investigated and was found to be of high quality by yielding wire pull strengths of up to 50% greater than was achieved previously with aluminum metallization and standard gold wire.

It is readily apparent that a bond between copper doped aluminum pads and copper doped gold wire is reliable and does not degrade the pad itself by introducing unwanted impurities into the pad which degrade the pad and, possibly, the connection.

Though the invention has been described with respect to a specific preferred embodiment thereof, many variations and modifications will immediately become apparent to those skilled in the art. It is therefore the intention that the appended claims be interpreted as broadly as possible in view of the prior art to include all such variations and modifications.

## Claims

1. An electrical connection of a wire to a bonding pad, comprising:

(a) a semiconductor chip having a bonding pad thereon comprising a first metal doped with a second metal;

(b) a wire comprising a third metal doped with the second metal and bonded to bonding pad.

2. The electrical connection of claim 1 wherein the first metal is aluminum.

3. The electrical connection of claim 1 wherein the second metal is copper.

4. The electrical connection of claim 1 wherein the third metal is gold.

(a) a semiconductor chip having a bonding pad thereon comprising aluminum doped with a second metal;

(b) a wire bonded to said bonding pad comprising gold doped with the second metal.

5. The electrical connection of claim 4 wherein the second metal is copper.

6. A bonding wire for electrically connecting to a semiconductor chip bonding pad of a first metal doped with a second metal, said bonding wire comprising a third metal doped with the second metal.

7. The bonding wire of claim 6 wherein the second metal is copper.

8. The bonding wire of claim 6 wherein the third metal is gold.

9. The bonding wire of claim 8 wherein the second metal is copper.

10. A bonding wire for electrically connecting to a semiconductor chip bonding pad of aluminum doped with a second metal, said bonding wire comprising a third metal doped with the second metal.

11. The bonding wire of claim 10 wherein the second metal is copper.

12. The bonding wire of claim 10 wherein the third metal is gold.

13. The bonding wire of claim 12 wherein the second metal is gold.

14. A method of making an electrical connection, comprising the steps of:

(a) providing a semiconductor chip having thereon a bonding pad of a first metal doped with a second metal;

(b) providing a wire of a third metal doped with the second metal; and

(c) bonding said wire to said bonding pad.

15. The method of claim 14 wherein the bonding step comprises ball bonding.

16. The method of claim 14 wherein the first metal comprises aluminum.

17. The method of claim 16 wherein the second metal comprises copper.

18. The method of claim 17 wherein the third metal comprises gold.

19. The method of claim 14 wherein the second metal comprises copper.

20. The method of claim 19 wherein the first metal comprises aluminum and one third metal comprises gold.

21. The method of claim 14 wherein the third metal comprises gold.

22. The method of claim 21 wherein the first metal comprises aluminum and the second metal comprises copper.